# EUROPEAN PATENT SPECIFICATION

(11) **EP 3 520 131 B1**
(45) Date of publication and mention of the grant of the patent: **17.03.2021**
(21) Application number: 17855058.8
(22) Date of filing: 27.09.2017
(51) Int. Cl.: H01J 37/317, C23C 14/00, C23C 14/34, C23C 14/54, C23C 14/56, C23C 14/08, H01J 37/34, C23C 14/22, H01J 37/32

(54) **A METHOD FOR CONTROLLING THE DEPOSITION RATE OF THIN FILMS IN A VACUUM MULTI-NOZZLE PLASMA SYSTEM AND A DEVICE FOR PERFORMING OF THE METHOD**
VERFAHREN ZUR STEUERUNG DER ABSCHEIDUNGSRATE VON DÜNNSCHICHTEN IN EINEM PLASMASYSTEM MIT MEHREREN DÜSEN UND VORRICHTUNG ZUR DURCHFÜHRUNG DES VERFAHRENS
PROCÉDÉ DE COMMANDE DU DÉBIT DE DÉPÔT DE FILMS MINCES DANS UN SYSTÈME PLASMA À BUSES MULTIPLES SOUS VIDE ET DISPOSITIF POUR LA MISE EN OEUVRE DU PROCÉDÉ

(30) Priority: 27.09.2016 CZ 20160603
(43) Date of publication of application: 07.08.2019
(73) Proprietor: Fyzikální ústav AV CR, v.v.i., 18221 Praha 8 (CZ)
(72) Inventor: OLEJNICEK, Jiri, 14300 Praha 4 - Modrany (CZ); SMID, Jiri, 14200 Praha 4 (CZ); HUBICKA, Zdenek, 15200 Praha 5 - Hlubocepy (CZ); ADAMEK, Petr, 37006 Ceske Budejovice 5 (CZ); CADA, Martin, 19800 Praha 9 (CZ); KMENT, Stepan, 77900 Olomouc (CZ)
(86) International application number: PCT/CZ2017/050044
(87) International publication number: WO 2018/059609

(56) References cited:
- WO-A1-2010/099218
- WO-A2-02/43466
- GB-A- 2 528 141
- JP-A- 2006 131 929
- JP-A- 2013 072 100
- US-A1- 2010 078 309
- US-A1- 2012 138 452

## Description

### Technical Field

The present invention belongs to the field of application of technological processes of thin film deposition, namely pure metals, their oxides, nitrides or other compounds, on the surface of the substrate, and relates to a method for controlling the deposition rate in a vacuum multi-nozzle plasma system and a device for performing of this method using plasma-chemical reactions in an active zone of generated discharge. The solution is suitable for application in the technology of plasma nozzle working in the principle of hollow cathode discharge burning in hollow cathode arc (HCA) regime.

### Background Art

The hollow cathode discharge as a technological tool for the deposition of thin films has been known since the 1980s. In practice, low-pressure hollow cathode (HC) systems are typically made up of a reactor in the form of a ground metal chamber in which the working pressure is maintained in the range of 10⁻⁵ to 10² Pa by means of a turbo-molecular pump. The inert working gas flows into the reactor through a nozzle, which serves at the same time as an electrode. This hollow cathode is made of a material which will form the sputtered film. To prevent overheating of the hollow cathode, the nozzle is usually cooled by water that flows through a copper cooler which is directly connected with the nozzle. Through the nozzle, only inert working gas such as argon is usually supplied to the system, while reactive gases such as oxygen or nitrogen are fed separately to the reactor. The working gas flow through the nozzle can be regulated so the gas velocity can be both supersonic and subsonic depending on the working pressure. The generation of plasma and the ignition of the discharge occurs at the end of the hollow cathode. The discharge is then carried by the flowing gas into the reactor, where an intense plasma-chemical channel is formed. This plasma-channel can be used for technological purposes such as thin film deposition, surface treatment, etc. The discharge in the hollow cathode removes material from the nozzle surface, and these sputtered particles are carried by the plasma channel towards the substrate, where they form the deposited film. The advantage of the described system is the fact that the particle flow to the substrate is caused not only by the diffusion of the positively charged particles (like the magnetron), but is due to the subsonic or supersonic working gas stream. This fact can be successfully used for deposition of thin films on substrates of complicated shapes, e.g. into cavities, as described, for example, in the patent document CZ 283407 entitled "Způsob a zařízení pro vytváření povlaku na vnitřních stěnách dutých substrátů, zejména trubic". Another advantage of using these methods is the possibility of depositing magnetic films because the magnetic field generated by the deposited film only very little affects the flow of particles to the substrate. However, the key advantage of hollow cathode discharge compared to magnetron sputtering is the high deposition rate even in reactive mode. Because through the nozzle flows only inert working gas (for example Ar, He, etc.), there is no oxidation of the nozzle during the deposition process and no covering of its inner surface with a thin dielectric film. This phenomenon, referred as "target poisoning," negatively affects the deposition speed of reactive sputtering in magnetron systems. Depending on the flow rate of the reactive and non-reactive working gas component, depending on the target material, on the discharge excitation mode and, depending on the power absorbed in the discharge, the deposition rate of reactive sputtering can drop to a fraction of the deposition rate when pure metal is sputtered. In case of a hollow cathode discharge, the sputtered material and reactive working gas components get in the contact only outside of the nozzle and the required chemical reaction takes place outside the erosion zone of the sputtered target. Therefore, the deposition rate of reactive sputtering is, in the case of a hollow cathode, fully comparable to the deposition rate of non-reactive sputtering.

Appropriate modifications of the initial configuration of the hollow cathode enabled significantly increase the deposition speed in recent years. For example, by using the pulse modulation instead of the continuous mode, it was possible to achieve higher values of the mean discharge current and, therefore, larger quantities of sputtered particles while maintaining the same thermal load. This was experimentally verified, for example in Hubička Z., Cada M., Potůček Z., Ptáček P., Šíchová H., Málková Z., Jastrabík L. and Trunda B., Low pressure deposition of LixZnyO thin films by means of RF plasma jet system, Thin Solid Films 447, 656 (2004). Another significant modification with a positive effect on the deposition rate was the use of the so-called "hollow cathode arc" (HCA) regime, whose theory is described in detail, for example, in the work: CM Ferreiraa and JL Delcroix, Theory of the hollow cathode arc, Journal of Applied Physics 49, 2380 (1979). In case of HCA, the hollow cathode nozzle, or at least its bottom part, is not cooled by water and, after discharge ignition significant increase of nozzle temperature occur as a consequence of ion bombardment. In the state of thermal equilibrium, the inner side of the nozzle is heated by impinging ions and the outside part is cooled by thermal radiation. Depending on the material of the nozzle, the hollow cathode can be heated to more than 1500 °C, thus the thin film grows not only due to sputtering of the target but also thanks to evaporation of the nozzle. With increasing temperature, the evaporation vs sputtering rate is higher. This method has been used, for example, in the deposition of CrN films as described in Baránková H., Bárdoš, L., and Gustavsson L.-E., High-Rate Hot Hollow Cathode Arction of Chromium and Chromium Nitride Films, Surface & Coatings Technology 188-189, 703 (2004).

When comparing the use of hollow cathode technology with magnetron sputtering, some disadvantages can also be noted. A large handicap of hollow cathode sputtering is, for example, a high inhomogeneity of the deposited film. In contrast to the magnetron, where the size of the uniformly covered surface area corresponds approximately to the size of the sputtered target, the thickness profile of the films sputtered by the hollow cathode is always nonhomogeneous with a shape of symmetrical two-dimensional Gaussian curve. The inhomogeneity of films sputtered by the hollow cathode grows with decreasing distance between the nozzle and the substrate. However, with increasing distance, the deposition rate in the symmetry axis decreases significantly. Unfortunately, good film homogeneity and high deposition rate are key requirements for successful industrial application of HC systems. To achieve these two objectives, several modifications of the original hollow cathode configuration have been tested in recent years. One of them is, for example, the use of two planar targets placed parallel to one another, as described, for example, by Kubo Y., Iwabuchi Y., Yoshikawa M., Sato Y. and Shigesato Y., High rate deposition of photocatalytic TiO2 films with high activity by the hollow cathode gas-flow sputtering method, Journal of Vacuum Science & Technology A 26, 893 (2008). This technique is known as gas-flow sputtering (GFS) and was first described in 1989 in Ishii K. High-rate low-kinetic energy gas-flow-sputtering system, Journal of Vacuum Science & 1989). In principle, this technique is similar to a hollow cathode discharge, the deposition rates at reactive sputtering are significantly higher compared to conventional magnetron sputtering, and the homogeneity of deposited films is fully comparable with the magnetron.

Another possible way how to compensate a thickness inhomogeneity of the films prepared by hollow cathode discharge is to utilize a so called 'multi-nozzle system' e.g. few cathodes lined up next to each other so either (a) all the plasma channels forms a homogenous plasma wall or (b) the proximity of the neighboring channels compensate decrease of deposition rate at the peripheral parts of the plasma channel. The most common technique of controlling the thin films deposition rate is either electric current regulation or power regulation, both specific for every nozzle. It is a proven fact that in case of magnetron sputtering these regulation techniques are fully sufficient, whereas for the hollow cathode discharge the above mentioned techniques are usable only in the glow discharge regime. It was found that for low power and electric current values the deposition rate grows with the absorbed power. Consequently, the temperature of the uncooled part of nozzle rise as well thus leads to increase of the thermo-emission. When the transition point between the glow discharge regime and the HCA regime is reached, one can observe a significant drop of voltage so as a drop on an absorbed power. Nevertheless, the nozzle temperature and the deposition rate keep rising. Based on the given facts, it is obvious that in case of hollow cathode operating in the HCA regime the deposition rate is not defined solely as a function of the absorbed power and the power regulation for high deposition rates is complicated.

Different regulation approaches were also tested lately. For example, the paper US 20120193219 A1 - "Method for determining process-specific data of a vacuum deposition process" describes a regulation method using the optical emission spectroscopy for controlling of some deposition parameters of magnetron-sputtered thin films. Another paper - US 4166783 A - "Deposition rate regulation by computer control of sputtering systems" shows a feedback regulation of deposition speed based on the computer-controlled power monitoring. There can be found various patented techniques of controlled thin films deposition (see for example US5234561A or WO9002216A), neither of which can be applied on the hollow cathode discharge in the HCA regime

Further relevant prior art is disclosed in patent documents GB 2 528 141 A and US 2012/138452 A1.

The present invention discloses a novel method of controlling of the deposition rate in a multi-nozzle sputtering system and a device for performing of the above mentioned method, wherein the invention utilizes plasma-chemical reactions in an active zone of the generated discharge, where a simple regulation mechanism is used for a reliable control of deposition rate of all hollow cathodes forming the multi-nozzle plasma system.

### Summary of Invention

The desired objective is achieved by the present invention which is, according to one aspect, a method of controlling deposition rate of a film in a vacuum multi-nozzle plasma system utilizing plasma-chemical reactions in an active discharge zone generated by a deposition system according to claim 1.

The deposition system, carrying the method according to the invention, comprises at least one row of plasma nozzles whose working tubes are terminated by a hollow cathode wherein an output of the cathode is placed at an upper part of a substrate holder with a stored substrate.

Principle of method according to the invention is based on monitoring of temperature of each hollow cathode by means of contactless temperature measurement during the deposition of the film on the substrate after the individual ignition of the discharge in each plasma nozzle. After evaluation of the measured values and the actual parameters, the effective current in each of the plasma nozzles is adjusted by the control unit so the deposition rates of all hollow cathodes are the same.

In preferred embodiment, the average value of current is regulated in the case of a DC discharge. In the case of a pulse modulated discharge, duty cycle is regulated.

According to another embodiment, the means of contactless temperature measurement can be a contactless pyrometer, preferably infrared contactless pyrometer.

According to another aspect, the present invention provides a device for performing of a method of controlling the deposition rate of film deposition in a vacuum multi-nozzle plasma system utilizing plasma-chemical reactions in an active zone of generated discharge according to claim 8. This deposition system comprises at least one row of plasma nozzles having operating tubes terminated by a hollow cathode where an output of the cathode is located at an upper part of a holding system with the stored substrate.

Principle of the device, according to the present invention, is based on arrangement of the components inside a vacuum chamber. The device further comprises a means of contactless temperature measurement directed to an end part of the hollow cathode in order to monitor its surface temperature; and wherein the means of contactless temperature measurement is connected to a control unit further connected to voltage sources of the individual plasma nozzles and the drive mechanism of the holding system.

In one embodiment of the invention, at the same plane of the hollow cathodes, the device further comprises additional openings in a housing of the vacuum chamber equipped with transparent apertures, wherein outside of the vacuum chamber behind every window, there is the means of contactless temperature measurement installed and focused on the output of each hollow cathode in order to measure its surface temperature.

According to one preferred embodiment, the chamber further comprises at least two rows or at least two pair rows of plasma nozzles where the hollow cathodes in each row are equidistantly disposed so between each adjacent plasma nozzle is at the same distance (d).

Plasma nozzles that are in opposite positions are dislocated by the half distance (d/2) to each other in perpendicular direction to the substrate movement and both of rows are adjusted against each other in an oblique direction in such way that the intersection of the planes extending through their longitudinal axes lies in the plane of deposited substrate.

The present invention achieves a new and higher effect which can enable high-speed deposition of homogeneous film deposited by reactive sputtering using the hollow cathode discharge burning in HCA mode. In comparison with standard methods of DC reactive magnetron sputtering the deposition rate can be up one order higher and approximately 2x to 3x higher than in case of classic hollow cathode discharge or GFS method burning in glow discharge mode and furthermore the homogeneity of the sputtered films is maintained at a predetermined level. The great advantage of the described method is that it is completely modular and therefore it can be extended to cover an arbitrarily large area.

### Brief Description of Drawings

Specific examples of realization of device according to the invention are shown in the enclosed drawings, where
Fig. 1 is a general scheme of a basic realization of the device,
Fig. 2 is a simplified plan view of the device in Fig. 1, showing the reciprocal arrangement of two adjacent rows of plasma nozzles,
Fig. 3 is an operational algorithm of control unit for each particular nozzle,
Fig. 4 is a graphical representation of the thickness profile of the formed thin films sputtered by the multi-nozzle system from different distances according to the invention,
Fig. 5 is a graphical representation of the deposition rate as a function of the absorbed power,
Fig. 6 is a graphical representation of the deposition rate as a function of the hollow cathode temperature,
Fig. 7 is a simplified plan view of an alternative realization of the device equipped with a single row of plasma nozzles,
Fig. 8 is a simplified plan view of an alternative realization of the device equipped with two pairs of plasma nozzle rows, and
Fig.9 is a general scheme of an alternative realization of the device equipped with two pairs of plasma nozzle rows.

Drawings illustrating the present invention and demonstrating its operation, and the following examples of specific realizations do not in any way limit the scope of protection specified in the definition but merely illustrate the principle of the solution.

### Description of Embodiments

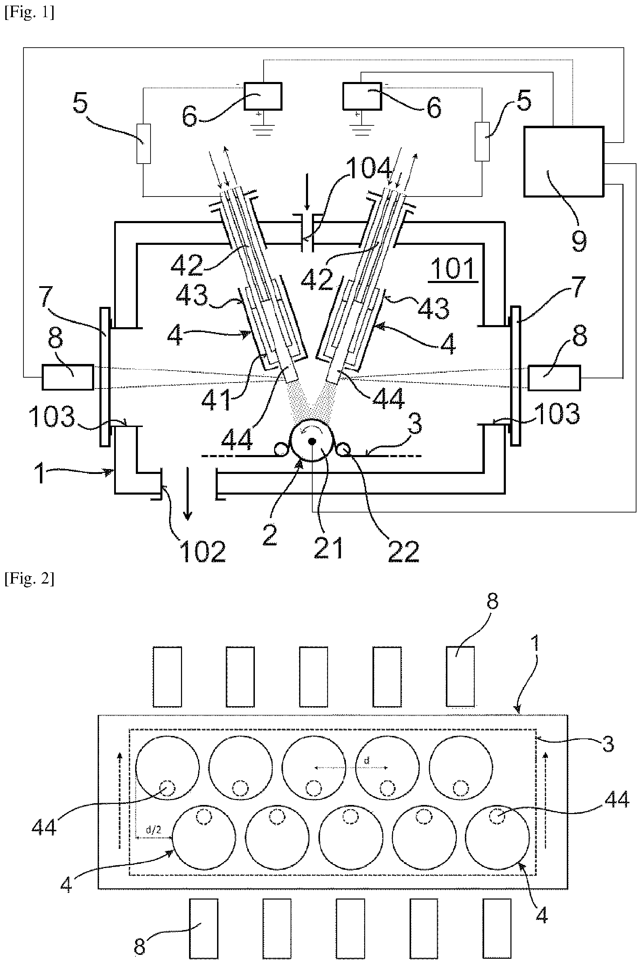

In a basic realization shown in Fig. 1 and Fig. 2, a device allowing the implementation of the method for controlling the deposition rate of thin films in a vacuum multi-jet plasma system according to the invention is formed by a vacuum chamber 1 in which inner space 101 the support assembly 2 for substrate 3 is installed. The support assembly 2 is formed by a system consisting of a cooled roll 21 provided with a not shown driving mechanism, and the guiding rollers 22 where the substrate 3 (for example an elastic foil) moves.

Vacuum chamber 1 is normally connected to not shown pumping unit (for example vacuum pump) via connecting neck 102 and also not shown disjunctive control valve. A reactive gas inlet 104 is installed to the inner space 101 of the vacuum chamber 1 from upper side and there are also two rows of plasma nozzles 4 installed in unmarked flanges through the jacket of the vacuum chamber 1 so that the hollow cathodes are located close to the upper side of the support assembly 2 where the substrate 3 is mounted. Plasma nozzles 4 in each row are equidistantly disposed so the distance (d) between each adjacent hollow cathode is the same. Plasma nozzles 4 that are in opposite positions in rows are dislocated by the half distance (d/2) to each other in perpendicular direction to the substrate 3 movement as shown Fig.2 and both of rows are adjusted against each other in an oblique direction in such way that the intersection of the planes extending through their longitudinal axes lies in the plane of deposited substrate 3. Individual plasma jets 4 are formed by a cooler 41, preferably made of copper, through which a coolant flows, for example water, and which is connected to the voltage source 6 via a protective resistor 5. The cooler 41 tightly surrounds the hollow cathode 44 where the output part overlaps the lower edge of the cooler 41 by around 15 to 20 mm and which is connected to the operating tube 42, through which a working gas flows. The cooler 41 itself is externally surrounded by an insulating cover 43, for example ceramic or quartz, preventing ignition of spurious discharges during the deposition.

At the same plane of hollow cathodes 44 plasma nozzles 4 there are additional apertures 103 in the jacket of chamber 1 equipped with transparent windows 7, which are made from for example borosilicate glass. Behind every window 7 there is infrared pyrometer 8 installed outside of the vacuum chamber 1 and focused on the output of each hollow cathode 44 in order to measure its surface temperature. The entire device is equipped with control unit 9 where all pyrometers 8 are connected as well as power sources 6 for all plasma nozzles 4 and the drive mechanism of cooled roll 21 of support assembly 2.

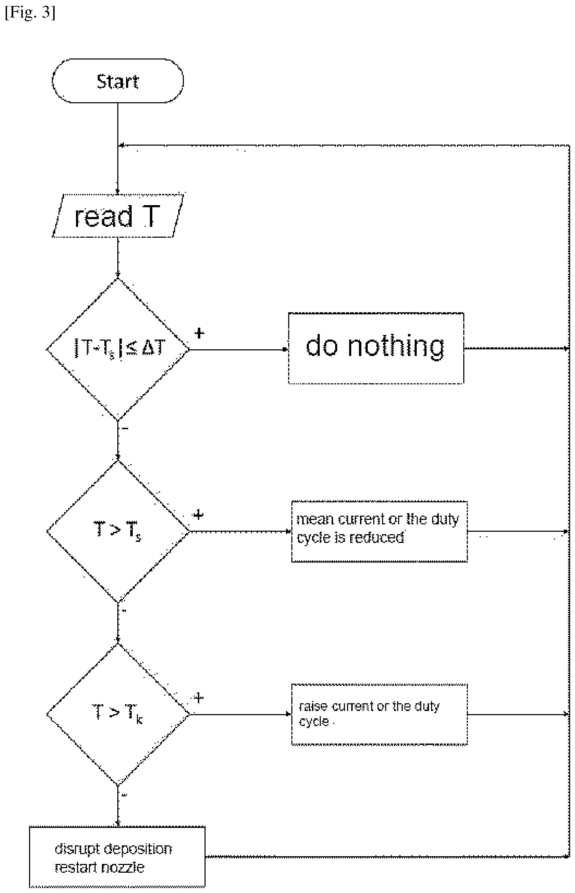

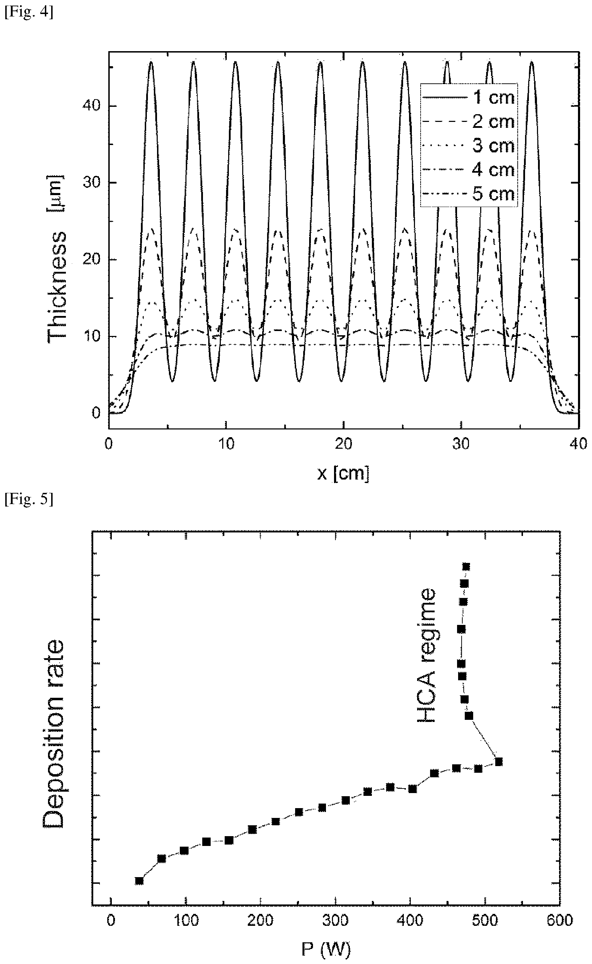

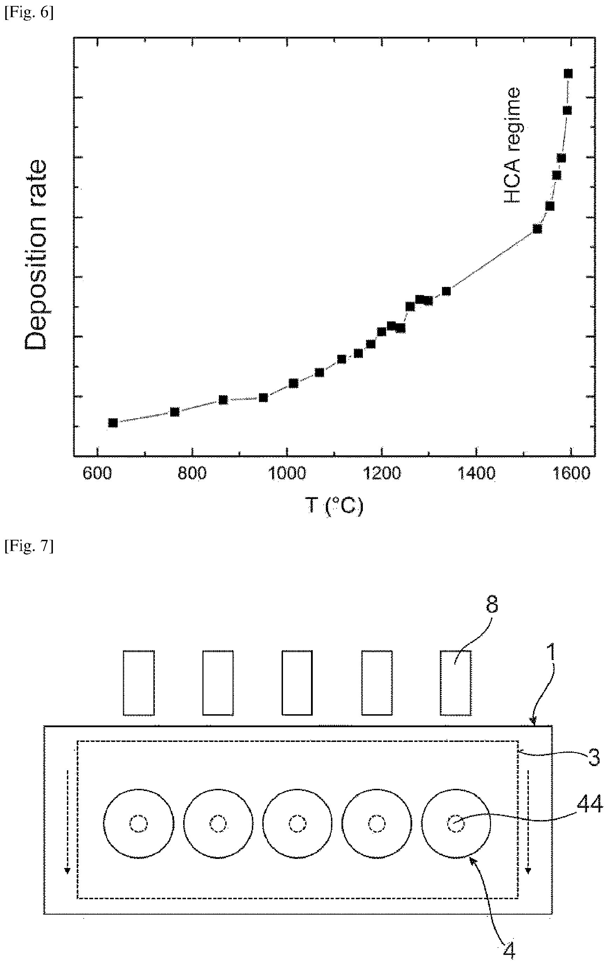

During deposition of the thin film on the substrate 3 a discharge is ignited in each hollow cathode plasma jet independently, the parameters of which are controlled by means of an external voltage source 6. The bottom part of the hollow cathode 44 protruding from the copper cooling block 41 is not being effectively cooled and due to the ion bombardment is being heated to high temperatures exceeding 1000°C even at low discharge currents. The actual surface temperature of the individual hollow cathodes 44 is measured by a contactless infrared pyrometer 8. The data are sent to the control unit 9 where they are processed and according to which the discharge current is regulated. The operation of the control unit 9 follows the algorithm depicted in Fig.3. The control unit 9 regulates the effective current value depending on the regime of the discharge in each plasma jet 4. In the DC regime the mean current value is regulated. In the case of the pulsed regime the duty cycle of the pulses is regulated, which means that the proportion of the active to the passive period is controlled. The control unit 9 tests the deviation of the actual temperature from the required temperature and if it is higher than the allowed tolerance ΔT, either the mean current or the duty cycle is reduced and vice versa. The only exception is when an arc discharge arises. If during the deposition process an arc discharge is ignited between the exiting part of the hollow cathode 44 and any anode inside the vacuum chamber 1, then it is always accompanied by abrupt drop of the temperature of the respective hollow cathode 44 either below the critical temperature Tk or below the minimum measurable temperature of the respective pyrometer 8. In such a case the control unit 9 interrupts the deposition process, e.g. by moving a shutter, which is not depicted, in between the system of plasma jets 4 and the substrate 3, until the steady deposition conditions are retrieved. The primary task of the control unit is to maintain the temperature of all hollow cathodes 44 during the deposition process at equal values, so that the deposition speeds of the individual plasma jets 4 are equal. For this simple regulation mechanism to be able to work, it is necessary, that all the hollow cathodes 44 are made of the same material, have equal geometrical dimensions (i.e. length, inner and outer diameter), have an equal distance from the substrate 3 and that the flow rates of the working gas through the hollow cathodes are equal. From the experiments performed it follows that when these conditions are fulfilled, the deposition speed is unambiguously given by the temperature, which is graphically illustrated in Fig 6. The dependence of the deposition rate on the power is depicted in Fig. 5. The Fig 4. illustrates a comparison of thickness profiles of the thin films deposited by the system with multiple hollow cathodes according to this invention at different substrate to hollow cathodes distances. According to Fig 4. it can be stated that, e.g. for the titanium hollow cathodes 44 with inner diameter of 6 mm at argon flow rate of cca. 200 sccm, working pressure of 15 Pa and at substrate 3 to hollow cathode 4 distance of 5 cm, the obtained film has a Gaussian profile with the variance of σ ≈ 1.9 cm. In this case to obtain a film with the maximum inhomogeneity of 10 % it is sufficient to place the individual plasma jets 4 with a spacing of 4.4 cm from each other, however, this holds only under the assumption, that the deposition rate of all the plasma jets 4 are equal.

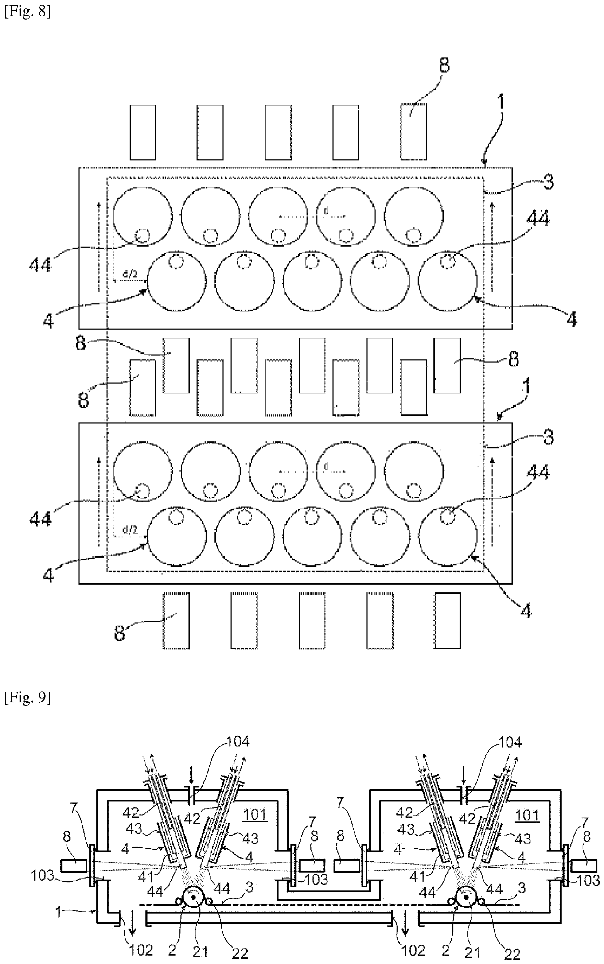

The described construction of the device is not the only possible implementation according to the invention, yet, as it is apparent from Fig. 3., just one row of the plasma jets 4 can be installed into the inner volume 101 or according to Fig. 8 and Fig. 9, the device can be equipped with two pairs of rows of plasma jets 4. The support assembly 2 for the substrate 3 does not need to be necessarily composed of the cooling cylinder 21 and the alignment cylinders 22, yet it can be comprised of a horizontally movable flat table equipped with means to hold the substrate 3, e.g. a desk or a plate, on which the thin film is being deposited.

### Industrial Applicability

A method of controlling the deposition rate of film in a vacuum multi-nozzle plasma system and device for performing of the method constructed according to the invention are suitable to be applied in all industrial fields dealing with high-speed plasma deposition of thin films. Albeit it can be utilized for deposition of pure metal films, the main application lies especially in the reactive sputtering of oxide compounds such as TiO₂, Al₂O₃, Fe₂O₃, ZrO₂, WO₃, ZnO and more others.

## Claims

1. A method of controlling deposition rate of a film deposition in a vacuum multi-nozzle plasma system utilizing plasma-chemical reactions in an active discharge zone, wherein the system comprises:
at least one row of plasma nozzles (4);
working tubes (42) of the nozzles (4) terminated by a hollow cathode (44);
wherein
an output of the cathode (44) is located at an upper part of a substrate holder (2) with a stored substrate (3),
**characterized in that** after individual ignition of the discharges in each plasma nozzle (4) and during the controlling of their parameters by means of external voltage sources (6) and during the deposition of the film on the substrate (3), the method comprises the steps of:
temperature monitoring of each hollow cathode (44) by means of contactless temperature measurement (8) ;
evaluation of the measured temperature values; and based on the evaluation
setting parameters of the discharge using a control unit (9) to regulate the effective current in each of the plasma nozzle (4) so that the deposition rates of all hollow cathodes (44) of plasma nozzles (4) are the same.

2. The method according to claim 1, wherein the discharge is a DC discharge, the method is **characterized in that** average current is regulated.

3. The method according to claim 1, wherein the discharge is a pulse-modulated discharge, the method is **characterized in that** duty cycle is regulated.

4. The method according to anyone of the claims 1 - 3, **being characterized in that** the method comprises testing of deviation of actual temperature from required temperature by the control unit (9).

5. The method according to claim 4, **being characterized in that** the method comprises the step of reduction or rising the actual temperature if the deviation is higher than the allowed tolerance ΔT.

6. The method according to claim 5 wherein if the actual temperature of the hollow cathode (44) is below the critical temperature *Tₖ* or below the minimum measurable temperature of the means of contactless temperature measurement (8), the method interrupts the deposition process via control unit (9).

7. The method according to claim 6, **being characterized in that** the interruption is provided by moving a shutter in between the nozzles (4) and the substrate (3) until the steady deposition conditions are retrieved.

8. A device for performing of method of controlling the deposition rate of film deposition in a vacuum multi-plasma-jet system utilizing plasma-chemical reactions in an active discharge zone, wherein the system comprises at least one row of plasma nozzles (4) having working tubes (42) terminated by a hollow cathode (44), wherein an output of the cathode (44) is located at an upper part of a substrate holder (2) with the stored substrate (3), **characterized in that** the device comprising:
a means of contactless temperature measurement (8) directed to an end part of the hollow cathode (44) in order to monitor its surface temperature;
and wherein
the means of contactless temperature measurement (8) is connected to a control unit (9) and further connected to voltage sources (6) of the individual plasma nozzles (4) and the drive mechanism of the holding system (2).

9. The device according to claim 8, **characterized in that,** the device further comprises openings (103) in a housing of the vacuum chamber (1), wherein the openings (103) are located at the same plane as the hollow cathodes (44) of the plasma nozzles (4); and wherein the openings (103) further comprise transparent apertures (7) equipped with the means of contactless temperature measurement (8) outside the vacuum chamber (1).

10. A device according to claim 8 or 9, **characterized in that** the vacuum chamber (1) comprising at least two rows or two pairs of plasma nozzle (4), wherein the plasma nozzles (4) in each row or pairs are equidistantly positioned so that between each two adjacent plasma nozzles, the same distance (d) is provided.

11. The device according to claim 10, wherein the row of opposing plasma nozzles (4) are mutually displaced in a direction perpendicular to the moving of the substrate (3) by half of the distance (d/2).

12. The device according to claim 11, wherein the plasma nozzles (4) in the at least two rows are positioned in an oblique direction with respect to the position of the substrate (3) such that the intersection of the planes extending through their longitudinal axes lies in the plane of the deposited substrate (3).

13. The device according to anyone of the claims 8 - 12, wherein the nozzles (4) comprise a cooler (41), preferably made of copper, through which a coolant flows, preferably water, connected to the voltage source (6) via a protective resistor (5).

14. The device according to claim 13, wherein the cooler (41) surrounds the hollow cathode (44) wherein the output part overlaps a lower edge of the cooler (41) and wherein the output part is connected to the operating tube (42) through which a working gas flows.

15. The device according to claims 12 or 13 or 14, wherein the cooler (41) is surrounded by an insulating cover (43), preferably ceramic or quartz, preventing ignition of spurious discharges during the deposition.

## Patentansprüche

1. Verfahren zum Steuern der Abscheidungsrate einer Schichtabscheidung (Filmabscheidung) in einem Vakuum-Plasma-System mit mehreren Düsen unter Verwendung plasmachemischer Reaktionen in einer aktiven Entladungszone, wobei das System umfasst:
mindestens eine Reihe von Plasmadüsen (4);
die Arbeitsrohre (42) der Düsen (4), die durch eine Hohlkathode (44) abgeschlossen sind; wobei sich ein Ausgang der Kathode (44) an einem oberen Teil eines Substrathalters (2) mit einem gespeicherten Substrat (3) befindet,
**dadurch gekennzeichnet, dass** nach individueller Zündung der Entladungen in jeder Plasmadüse (4) und während der Steuerung ihrer Parameter mittels externer Spannungsquellen (6) und während der Abscheidung der Schicht auf dem Substrat (3), das Verfahren die folgenden Schritte umfasst:
Temperaturüberwachung jeder Hohlkathode (44) mittels berührungsloser Temperaturmessung (8);
Auswertung der gemessenen Temperaturwerte; und basierend auf den Bewertungseinstellungsparametern der Entladung unter Verwendung einer Steuereinheit (9) zur Regulierung des Effektivstroms in jeder der Plasmadüsen (4), so dass die Abscheidungsraten aller Hohlkathoden (44) der Plasmadüsen gleich sind.

2. Verfahren nach Anspruch 1, wobei die Entladung eine DC Entladung (Gleichstromentladung) ist; das Verfahren ist **dadurch gekennzeichnet, dass** der durchschnittliche Strom geregelt wird.

3. Verfahren nach Anspruch 1, wobei die Entladung eine pulsmodulierte Entladung ist; das Verfahren ist **dadurch gekennzeichnet, dass** das Tastverhältnis geregelt wird.

4. Verfahren nach einem der Ansprüche 1 bis 3 **dadurch gekennzeichnet, dass** das Verfahren die Überprüfung der Abweichung der tatsächlichen Temperatur von der erforderlichen Temperatur durch die Steuereinheit (9) umfasst.

5. Verfahren nach Anspruch 4, **dadurch gekennzeichnet, dass** das Verfahren den Schritt des Verringerns oder Erhöhens der tatsächlichen Temperatur umfasst, wenn die Abweichung höher als die zulässige Toleranz ΔT ist.

6. Verfahren nach Anspruch 5, wenn die tatsächliche Temperatur der Hohlkathode (44) unter der kritischen Temperatur *Tk* oder unter der minimalen messbaren Temperatur der Mittel zur berührungslosen Temperaturmessung (8) liegt, unterbricht das Verfahren den Abscheidungsprozess über die Steuereinheit. (9).

7. Verfahren nach Anspruch 6 **dadurch gekennzeichnet, dass** die Unterbrechung durch Bewegen eines Verschlusses zwischen den Düsen (4) und dem Substrat (3) bereitgestellt wird, bis stabile Abscheidungsbedingungen erhalten werden.

8. Vorrichtung zur Durchführung eines Verfahrens zur Steuerung der Abscheidungsrate der Schichtabscheidung (Filmabscheidung) in einem Vakuum-Multi-Plasma-Jet-System unter Verwendung plasmachemischer Reaktionen in einer aktiven Entladungszone, wobei das System mindestens aus einer Reihe von Plasmadüsen (4) mit Arbeitsrohren (42) besteht, die durch eine Hohlkathode (44) abgeschlossen sind, wobei sich ein Ausgang der Kathode (44) an einem oberen Teil eines Substrathalters (2) mit dem gespeicherten Substrat (3) befindet, **dadurch gekennzeichnet, dass** die Vorrichtung umfasst:
ein Mittel zur berührungslosen Temperaturmessung (8), das auf einen Endteil der Hohlkathode (44) gerichtet ist, um deren Oberflächentemperatur zu überwachen; und wobei
das Mittel zur berührungslosen Temperaturmessung (8) mit einer Steuereinheit (9) verbunden ist, und weiter mit Spannungsquellen (6) der einzelnen Plasmadüsen (4) und mit dem Antriebsmechanismus des Haltesystems (2) verbunden ist.

9. Vorrichtung nach Anspruch 8, **dadurch gekennzeichnet, dass** die Vorrichtung weiter Öffnungen (103) in einem Gehäuse der Vakuumkammer (1) umfasst, wobei sich die Öffnungen (103) auf gleicher Ebene wie die Hohlkathoden (44) der Plasmadüsen (4) befinden; und wobei die Öffnungen (103) weiter transparente Öffnungen (Aperturen) (7) umfassen, die mit den Mitteln der berührungslosen Temperaturmessung (8) außerhalb der Vakuumkammer (1) ausgestattet sind.

10. Vorrichtung nach Anspruch 8 oder 9, **dadurch gekennzeichnet, dass** die Vakuumkammer (1) mindestens zwei Reihen oder zwei Paare von Plasmadüsen (4) umfasst, wobei die Plasmadüsen (4) in jeder Reihe oder in Paaren äquidistant positioniert sind, so dass zwischen jeweils zwei benachbarten Plasmadüsen der gleiche Abstand (d) vorgesehen ist.

11. Vorrichtung nach Anspruch 10, wobei die Reihen gegenüberliegender Plasmadüsen (4) in einer Richtung senkrecht zur Bewegung des Substrats (3) um die Hälfte des Abstands (d/2) gegeneinander verschoben sind.

12. Vorrichtung nach Anspruch 11, wobei die Plasmadüsen (4) in den mindestens zwei Reihen in einer schrägen Richtung in Bezug auf die Position des Substrats (3) so positioniert sind, dass der Schnittpunkt der Ebenen, die sich durch ihre Längsachsen erstrecken, in der Ebene des abgeschiedenen Substrats liegt (3).

13. Vorrichtung nach einem der Ansprüche 8 bis 12, wobei die Düsen (4) einen Kühler (41), vorzugsweise aus Kupfer, umfassen, durch den ein Kühlmittel fließt, vorzugsweise Wasser, und der über einen Schutzwiderstand mit der Spannungsquelle verbunden ist (5).

14. Vorrichtung nach Anspruch 13, wobei der Kühler (41) die Hohlkathode (44) umgibt, wobei der Ausgangsteil eine Unterkante des Kühlers (41) überlappt und wobei das Ausgangsteil mit dem Betriebsrohr (42), durch das ein Arbeitsgas strömt, verbunden ist.

15. Vorrichtung nach den Ansprüchen 12 oder 13 oder 14, wobei der Kühler (41) von einer isolierenden Abdeckung (43), vorzugsweise Keramik oder Quarz, umgeben ist, um die Entzündung von Störentladungen während der Abscheidung zu verhindern.

## Revendications

1. Procédé de commande du débit de dépôt de film dans un système plasma à buses multiples sous vide utilisant des réactions chimiques de plasma dans une zone de décharge active, le système comprenant :
au moins une rangée de buses à plasma (4),
dont les tubes de travail (42) sont terminés par une cathode creuse (44), dont la sortie est située à la partie supérieure du porte-substrat (2) avec le substrat stocké (3),
**caractérisé en ce qu'**après l'allumage individuel des décharges dans chaque buse à plasma (4) et pendant la commande de leurs paramètres au moyen de sources externes de tension (6) et durant le dépôt du film sur le substrat (3), le procédé comprend les étapes suivantes :
le suivi de la température de chaque cathode creuse (44) par des moyens de mesure de température sans contact (8) ;
l'évaluation des valeurs de température mesurées ; et, à partir de cette évaluation,
le réglage des paramètres de la décharge à l'aide d'une unité de commande (9) afin de réguler le courant effectif dans chacune des buses à plasma (4) de sorte que la vitesse de dépôt de toutes les cathodes creuses (44) des buses à plasma (4) est identique.

2. Procédé selon la revendication 1, dans lequel la décharge est une décharge à courant continu, le procédé est **caractérisé en ce que** le courant moyen est régulé.

3. Procédé selon la revendication 1, dans lequel la décharge est une décharge modulée par impulsions, le procédé est **caractérisé en ce que** le cycle de travail est régulé.

4. Procédé selon l'une des revendications 1 à 3, **caractérisé en ce qu'il** comprend un essai de l'écart entre la température réelle et la température requise par l'unité de commande (9).

5. Procédé selon la revendication 4, **caractérisé en ce qu'il** comprend une phase de réduction ou d'augmentation de la température réelle dans le cas où l'écart est supérieur à la tolérance autorisée ΔT.

6. Procédé selon la revendication 5, dans lequel il interrompt le processus de dépôt par l'intermédiaire de l'unité de commande (9) si la température réelle de la cathode creuse (44) est inférieure à la température critique Tₖ ou inférieure à la température minimale, mesurée par des moyens de mesure de température sans contact (8).

7. Procédé selon la revendication 6, **caractérisé en ce que** l'interruption est assurée par le déplacement d'un obturateur entre les buses (4) et le substrat (3) jusqu'à ce que la stabilité du dépôt soit rétablie.

8. Dispositif pour la mise en œuvre du procédé de commande de débit de dépôt de film dans un système à jet multiplasma sous vide utilisant des réactions chimiques par plasma dans une zone de décharge active, dans lequel le système comprend au moins une rangée de buses à plasma (4) dont les tubes de travail (42) se terminent par une cathode creuse (44) dont la sortie est située à la partie supérieure d'un porte-substrat (2) avec le substrat stocké (3), **caractérisé en ce que** le dispositif comprend :
un moyen de mesure de température sans contact (8) dirigé vers l'extrémité de la cathode creuse (44) afin de contrôler sa température de surface ; et dans lequel
le moyen de mesure de la température sans contact (8) est relié à l'unité de commande (9) et est connecté aux sources de tension (6) des différentes buses à plasma (4) et au mécanisme d'entraînement du système de maintien (2).

9. Dispositif selon la revendication 8, **caractérisé en ce qu'il** comprend en outre des ouvertures (103) dans le logement de la chambre à vide (1),
dans lequel les ouvertures (103) sont situées dans le même plan que les cathodes creuses (44) des buses à plasma (4) ; et dans lequel
les ouvertures (103) comportent en outre des ouvertures transparentes (7) équipées de moyens de mesure de température sans contact (8) à l'extérieur de la chambre à vide (1).

10. Dispositif selon la revendication 8 ou 9, **caractérisé en ce que** la chambre à vide (1) comprend au moins deux rangées ou deux paires de buses à plasma (4), dans laquelle les buses à plasma (4) dans chaque rangée ou paire sont positionnées de façon équidistante afin qu'une même distance (d) soit prévue entre chaque paire de buses à plasma adjacentes.

11. Dispositif selon la revendication 10, dans lequel les rangées de buses à plasma se faisant face (4) sont réciproquement déplacées de façon perpendiculaire au déplacement du substrat (3) à un distance égale à la moitié de la distance (d/2).

12. Dispositif selon la revendication 11, dans lequel les buses à plasma (4) dans les deux rangées au moins sont positionnées en direction oblique par rapport à la position du substrat (3) de telle sorte que l'intersection des plans passant par leurs axes longitudinaux se trouve dans le plan du substrat déposé (3).

13. Dispositif selon l'une des revendications 8 à 12, dans lequel les buses (4) comprennent un refroidisseur (41), de préférence en cuivre, à travers lequel circule un fluide de refroidissement, de préférence de l'eau, relié à la source de tension (6) par le biais d'une résistance de protection (5).

14. Dispositif selon la revendication 13, dans lequel le refroidisseur (41) entoure la cathode creuse (44), dans lequel la partie de sortie et le bord inférieur du refroidisseur (41) se chevauchent et dans lequel ladite partie de sortie est reliée au tube de travail (42) à travers lequel circule un gaz de travail.

15. Dispositif selon les revendications 12, 13 ou 14, dans lequel le refroidisseur (41) est entouré d'un capot isolant (43), de préférence en céramique ou en quartz, empêchant que des décharges parasites ne se produisent pendant le dépôt.
